Europäisches Patentamt

European Patent Office

Office européen des brevets

(19)

(11) Publication number: 0 171 630

A2

(12) EUROPEAN PATENT APPLICATION

(21) Application number: 85108878.1

(22) Date of filing: 16.07.85

(51) Int. Cl.⁴: H 05 K 3/10
G 03 F 7/02

(30) Priority: 10.08.84 US 639636

(43) Date of publication of application:
19.02.86 Bulletin 86/8

(84) Designated Contracting States:
DE FR GB

(71) Applicant: International Business Machines Corporation
Old Orchard Road
Armonk, N.Y. 10504(US)

(72) Inventor: Canestaro, Michael J.
R.D. 3 Box 265 Dutchtown Road
Endicott New York 13760(US)

(72) Inventor: Parsons, Ralph E.
18 Newberry Drive
Endicott New York 13760(US)

(72) Inventor: Welsh, John A.
142 Helen Street
Binghamton New York 13905(US)

(72) Inventor: Mesley, Nimrod N.
P.O. Box 567
Endicott New York 13760(US)

(72) Inventor: Stephanie, John G.
1500 Carnegie Drive
Binghamton New York 13903(US)

(74) Representative: Suringar, Willem Joachim
IBM Nederland N.V. Patent Operations Watsonweg 2
NL-1423 ND Uithoorn(NL)

(54) System for producing high resolution circuit lines on a printed circuit board.

(57) A photohardenable element or structure (9) having a protective cover sheet (14), a substantially clear support layer (10) disposed beneath the cover sheet layer, and a photoresist layer (12) sandwiched therebetween. The protective cover sheet layer is removed, and the remaining two layers of the photohardenable element are laminated onto a plating substrate (16) to form a panel. Artwork is provided in contact with the support layer (10); the artwork and panel are exposed through the support layer to radiation; the support layer (10) of the photohardenable element is removed; and the panel is developed. Finally, the panel is plated with an electrical conducting substance to adhere to the plating substrate (16) to form electrical conductors and the photoresist (12) is removed.

In another embodiment, the protective cover sheet layer (14) of the photo-hardenable element (9) is removed, and the remaining two layers of the photohardenable element are laminated onto a plating substrate (16) covered with a thin layer of copper (18), to form a panel. Artwork is provided in contact with the support layer (10); the artwork and panel are exposed to radiation; the support layer of the photohardenable element is removed; and the panel is developed. Next, the panel is plated with an electrical conducting substance and then with tin. The photoresist (12) is removed. Finally, the thin copper layer (18) is etched in areas where printed circuit lines are not desirable and the tin is removed.

FIGURE 1.

0171630

## BACKGROUND OF THE INVENTION

The present invention relates to a system for producing printed circuit
boards and more particularly for using a photoresist structure to produce
high resolution circuit lines on said boards.

Two common methods are currently used for producing printed circuit boards.
One of the simplest processes consists of laminating copper foil onto a
dielectric substrate, normally epoxy prepreg (pre-loaded mat or fabric);
laminating a multi-layer photoresist structure, including a photoresist,
onto the copper foil; exposing the circuit pattern; developing the photoresist; and, in the areas where copper lines are undesirable, removing
the copper by etching. In a final step, the photoresist is stripped, leaving
the copper lines on the dielectric substrate.

One of the drawbacks of this process results from the etching of the copper
foil; the foil is undercut so that as thinner lines are etched the amount
of copper at the base of the lines decreases. In order to accumulate enough
copper on the substrate, only fairly wide lines (125-250 µm or larger) can
be produced with this process.

In order to obtain narrower lines (75-100 µm or less), a second method
of producing printed circuit boards which utilizes electroless plating of
the lines has been developed. There exist two primary embodiments of this
method. In the first, a layer of so called peel-apart copper is laminated
on the substrate. The peel-apart copper comprises a 50 µm copper carrier
layer bonded to a thin chromium interface layer which, in turn, is bonded
to a 5 µm copper layer having a dendritic surface. The peel-apart copper
is removed; the remaining copper surface is mechanically srubbed with
pumice, and an adhesion promoter, benzotriazole (BTA), is applied; a
photoresist structure is laminated onto the foil after the removal of the
protective cover sheet layer; artwork is placed next to the photoresist
and the latter is exposed through the support layer under the artwork
pattern; the support layer is removed from the photoresist; and the pattern
is developed. Next, the board is plated, first with copper and then with
tin. Finally, the photoresist is stripped, the undesired copper etched,
and the tin removed.

EN 9.84.009

In a simpler embodiment, disclosed in U.S. Patent No. 4,448,804, copper foil is laminated onto a substrate; this foil is then etched and seeded with palladium/tin; a photoresist structure is laminated onto the foil after the removal of the protective cover sheet layer; artwork is placed next to the photoresist and the latter is exposed through the support layer under the artwork pattern; the support layer is removed from the photoresist; and the pattern is developed. Finally, the board is plated with copper and the photoresist is stripped.

Problems which occasionally arise with these processes include mouseholes, or defects in the line patterns of the plating. In some cases, hole voids in the wall of the photoresist, indicating that in these areas the photoresist is not adequately polymerized or cross-linked, lead to the developer forming holes in the sidewall of the photoresist. During the copper plating, copper can plate into the side wall, causing a short circuit after the photoresist is removed.

Fluting of the sidewalls, which results in jagged circuit lines, is a further problem with these methods. This fluting becomes more of a problem as thinner lines are produced.

U.S. Patent No. 4,135,988 describes an alternative method for eliminating, in the plating of plated through-hole circuit boards, the problem of undercutting mentioned above. This process differs from the two methods of electroless plating previously described in that it uses a copper seeder/catalyst rather than a palladium/tin seeder. Furthermore, the copper plating must be stripped and the board replated to improve copper-to-copper adhesion after the photoresist has been removed. An additional plating is also necessary to achieve the desired copper thickness.

U.S. Patent No. 4,413,051 describes a method for providing high resolution, highly defined, thick film patterns. This method uses multiple layers of dry resist to achieve the desired patterns. Moreover, the polyester support sheet is peeled off of the photoresist structure and replaced on the top layer by a layer of oil. The removal of the support sheet prevents light leakage from off-axis rays and thus improves the definition of the resulting patterned resist. The oil is provided to prevent oxygen from reacting with free radicals in the photoresist sheet.

It would be advantageous to provide a system for producing fine line printed circuit cards by using a photolithographic process.

It would also be advantageous to improve the exisiting process for producing printed circuit cards having conductive lines with dimensions of less than 125 μm.

It would be further advantageous to be able to produce reliable printed circuit lines in a predictable manner without the current problems of mouseholes and fluting of the sidewalls.

It would also be advantageous to provide a system for photolithographically producing circuit boards with said system involving a minimum of light scattering, diffusion and diffraction. Such an improved process would result in improved definition of the patterned resist.

Furthermore, it would be advantageous to produce reliable printed circuit lines without the extra steps required by the prior art.

## SUMMARY OF THE INVENTION

It is a principal object of the invention to provide a method for manufacturing a substantially defect-free fine line printed circuit board and, more particularly, to eliminate the mouseholes and fluting in the circuit lines.

In accordance with the invention, there is provided a photohardenable element or structure having a protective cover sheet, a substantially clear support layer disposed beneath the cover sheet layer, and a photoresist layer sandwiched therebetween. The protective cover sheet layer is removed, and the remaining two layers of the photohardenable element are laminated onto a plating substrate to form a panel. Artwork is provided in contact with the support layer; the artwork and panel are exposed through the support layer to radiation; the support layer of the photohardenable element is removed; and the panel is developed. Finally, the panel is plated with an electrical conducting substance to adhere to the plating substrate to form electrical conductors and the photoresist is removed.

In an alternative embodiment, the protective cover sheet layer of the photohardenable element is removed, and the remaining two layers of the photohardenable element are laminated onto a plating substrate covered with a thin layer of copper, to form a panel. Artwork is provided in contact with the support layer; the artwork and panel are exposed to radiation through the support layer; the support layer of the photohardenable element is removed; and the panel is developed. Next, the panel is plated with an electrical conducting substance and then with thin. The photoresist is removed. Finally, the thin copper layer is etched in areas where printed circuit lines are not desirable and the tin is removed.

## BRIEF DESCRIPTION OF THE DRAWINGS

The foregoing and other objects, features, and advantages of the invention will be apparent from the following more particular description of the preferred embodiments of the invention, as illustrated in the accompanying drawings, in which:

FIG. 1 is a cross-sectional illustration of a photoresist structure being applied to a substrate;

FIG. 2 is a cross-sectional illustration of a photoresist structure being applied to both major surfaces of a substrate;

FIG. 3 is a flow diagram illustrating the preferred method of the invention; and

FIG. 4 is a flow diagram illustrating an alternative method of the invention.

## DETAILED DESCRIPTION OF THE PREFERRED EMBODIMENTS

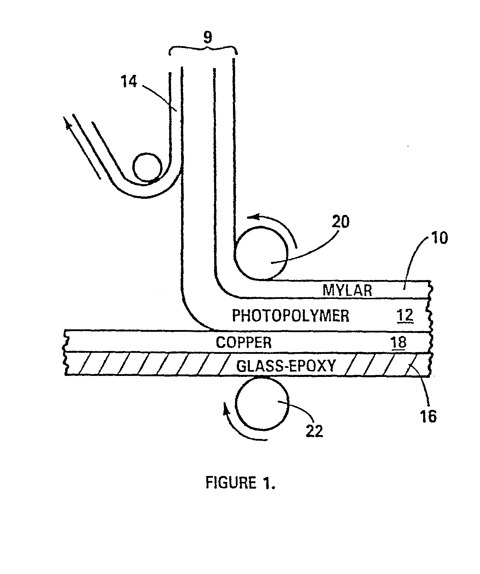

Referring now to FIG. 1, there is shown a photoresist structure 9. The photoresist structure 9 has a substantially clear support layer 10, such as Mylar clear polyester film model 92D, manufactured by E.I. Du Pont de Nemours. (Mylar is a registered trademark of E.I. Du Pont de Nemours Co., Inc.). A photopolymer 12, a light sensitive photopolymerizable material

EN 9.84.009

such as model T168 Du Pont photoresist, is bonded to the support layer 10. A polyethylene cover sheet 14 is bonded to the photopolymer 12. As shown, the polyethylene cover sheet 14 is stripped and the remaining two layers 10, 12 are applied to a glass/epoxy substrate 16 clad with copper 18. It should be understood that material other than epoxy glass can be used as a substrate. Electroless plating of copper can be accomplished with a wide variety of non-conductive dielectric substrates, especially thermoplastic and thermosetting resins and glass. Typical thermosetting polymeric materials include epoxy, phenolic base materials, and polyimides. The dielectric substrates may be molded of the polymers containing fillers and/or reinforcing agents such as glass filled epoxy or phenolic base materials. Suitable thermoplastic polymeric materials include polyolefins such as polypropylene, polysulfones, polycarbonates and nitrile rubbers. The top and bottom rollers 20 and 22 provide heat and pressure during the lamination process.

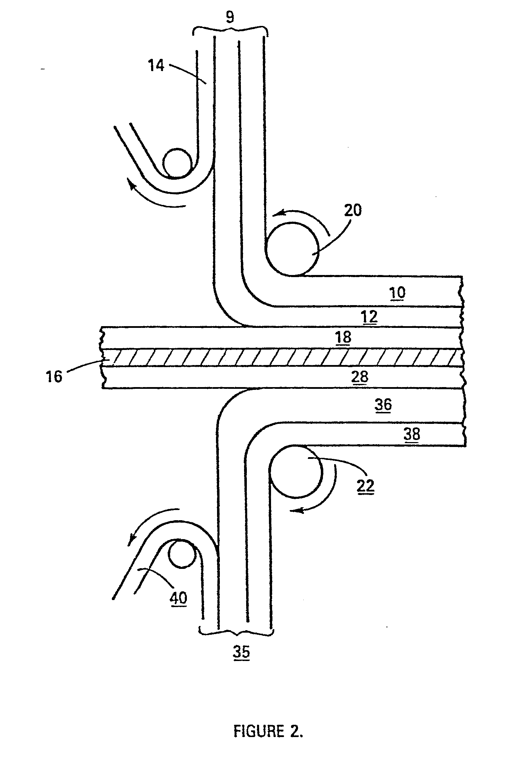

As illustrated also in FIG. 2, the photoresist structures 9 and 35 may be applied in the same manner to both sides of the glass/epoxy substrate 16 clad with copper 18 and 28. This provides for the production of circuit lines on both sides of the printed circuit board.

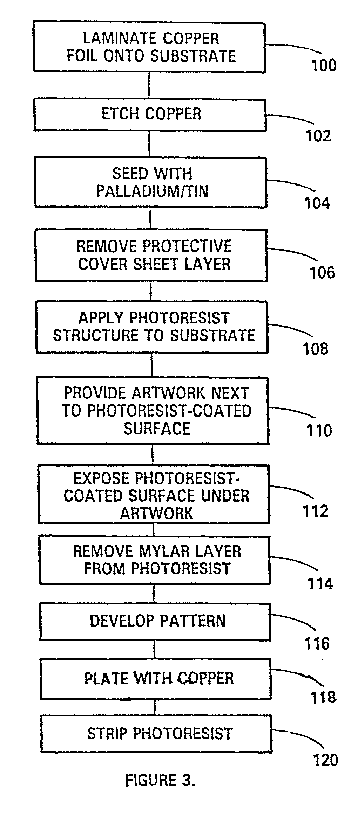

The photoresist structures 9 and/or 35 are used in the inventive method described in FIG. 3. The copper sheet 18 having a roughened surface is pressure laminated onto the surface of the dielectric substrate 16, step 100. Subsequently the copper is completely etched off, step 102, preferably by using an aqueous solution, free of complexing agents and containing $CuCl_2$ and HCl. An aqueous solution of persulfate can also be used as an agent. At this stage of the process, anchor points for the copper have developed at the surface to be plated. These anchor points facilitate the plating of copper afterwards and improve its adhesion to the surface.

If through-connections are to be formed in the substrate 16 to allow printed circuits on both sides of the substrate 16 to be connected, holes are now drilled through the substrate 16. Subsequently the holes are cleaned by sand or vapor blasting and by chemicals, such as by solvent swelling. It is also possible to produce the via holes prior to removing the copper sheet 18.

EN 9.84.009

Next is a cleaning step, not shown, where the substrate 16 is cleaned for about five minutes at a temperature of between 45°C and 60°C with an alkaline cleaner consisting of a solution containing sodium phosphate and sodium silicate and having a $p_H$ value of 13. The cleaner is rinsed off with deionized water having a temperature of between 45°C and 60°C.

Next, the substrate surface 16 is activated or seeded, step 104, by contact with a composition containing palladium chloride, HCl and stannous chloride, capable of initiating the electroless plating process. The seeding is performed in a one-step process. The substrate surface is brought into contact with the colloidal solution at room temperature for five minutes. However, the contact time can vary between 1 minute and 10 minutes.

The polyethylene cover sheet 14 is removed, step 106. The remaining two layers 10, 12 of the photoresist structure 9 are then laminated onto the board 16, step 108, by heat and pressure, forming a panel. The rollers used in this lamination, step 108, have a temperature of approximately 100°C and exert a pressure of between 179 and 207 kPa. If printed circuit lines are to be produced on both sides 18, 28 (FIG. 2) of the  board or panel 16, the photoresist structures 9, 35 are laminated on both sides of the dried substrate surface using the aforementioned temperature and pressure.

The support layer 10 of the photoresist structure 9 should be made of a material with a haze rating or value on the Gardener haze mater of less than 2%. Du Pont's Mylar, model 92D, is such a material, with a typical haze rating of 0.5%.

A hazy material tends to scatter light. Instead of collimated light exposing the line channels cleanly, the scattered light exposes the photoresist in areas which are not intended to be exposed or does not expose photoresist in areas that are intended to be exposed. This leads to the hole voids and fluting of the side walls described earlier. Replacing a hazy layer with a substantially clear Mylar layer solves these problems.

Next, the panel is exposed to ultraviolet radiation through a glass master pattern which contains the desired circuit lines by placing the glass master, now shown, into the expose machine, aligning the glass master and

EN 9.84.009

then placing the panel on top of the glass master. The expose machine then applies a vacuum to provide a tight seal between the support sheet 10 and the glass master. The resist 12 is exposed through the support sheet 10 by UV light to give the proper cross link density. After exposure, the clear support layer 10 is removed from the panel 16, step 114, and the photoresist 12 is developed, step 116, producing the negative of the desired circuit pattern on the photoresist foil 112. In the areas where the photoresist 12 has been removed in the development step 116, the catalyzed regions of the substrate surface 16 are exposed. The photoresist process has no detrimental effect on the catalyzed surfaces, including the through-holes. Next, copper is plated by electroless plating onto the exposed surface areas, step 118. The plating is done in two steps which differ in the composition of the baths used and in the duration of the step. Finally, the photoresist is stripped, leaving the circuit lines on the board, step 120.

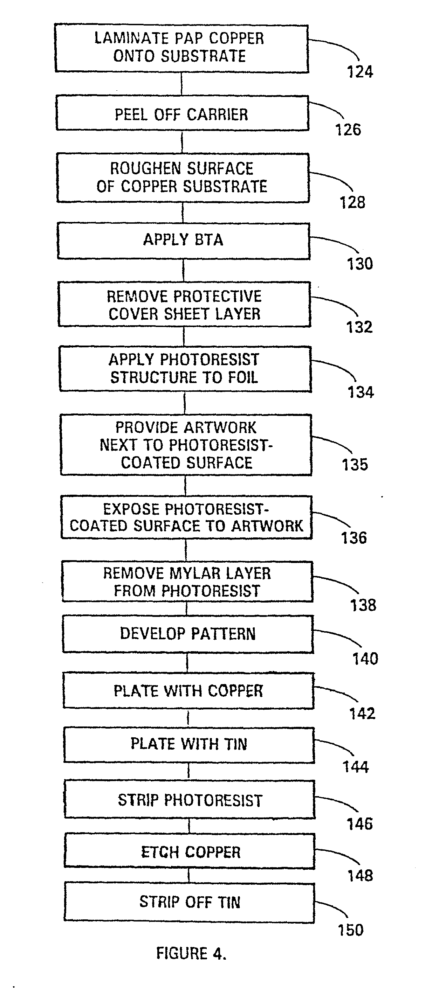

In an alternative method, as better understood with reference to FIG. 4, peel-apart copper is laminated onto a substrate, step 124. The peel-apart copper comprises a 50 μm copper layer bonded to a chromium interface layer having a thickness on the order of 5-10 nm. It should be understood that the carrier layer need not be copper; any suitable material onto which a thin layer of copper may be plated or deposited can be used. The chromium layer is bonded to a microthin (5 μm) copper layer having a dentritic surface. The underside of the 5 μm copper layer is a zinc surface treated to provide a thin zincate layer. The 50 μm copper carrier is used to protect the 5 μm copper layer from epoxy dust and small depressions during a subsequent lamination process. The chromium interface layer is essential for peeling the copper carrier foil from the 5 μm copper layer. The 5 μm copper layer is the base structure of printed circuit lines and has a dentritic surface to enhance mechanical bonding during the lamination process along with a zinc treatment. The zincate layer promotes adhesion between copper and epoxy. The basic structure is laminated by suitable heat and pressure to epoxy which may contain one or more internal copper planes that serve as signal and ground planes.

The copper carrier and chromium interface layers are then peeled off, step 126, leaving the 5 μm copper layer 18 on the epoxy laminate 16. Next, the copper surface is mechanically scrubbed with pumice to roughen the surface, step 128. The copper surface is then treated with a corrosion inhibitor and adhesion promoter, typically benzotriazole (BTA), by dipping the panels into a solution thereof, step 130. The adhesion promoter is necessary to prevent the photoresist from coming off in the plating bath.

After the adhesion promoter is coated onto the surface of the panels, the protective cover sheet layer 14 is removed from the photoresist structure 9 described above, step 132. The remaining two layers, 10 and 12, are laminated by heat and pressure onto one or both sides of the board, step 134.

The circuit board is then exposed to the glass master pattern, which contains the desired circuit lines, step 135, by placing the glass master into the expose machine, aligning the glass master, and placing the panel on top of the glass master. The expose machine applies a vacuum, creating a tight seal between the support layer 10 of the photoresist structure and the glass master. The photoresist is then exposed through the support layer 10 by ultraviolet light to give the proper cross link density. The clear support layer 10 of the photoresist structure is removed, step 138, and the pattern is developed, step 140.

In the areas where the photoresist is not exposed, which are the areas where circuit lines should be present, the unexposed photoresist is developed out or chemically removed with methylchloroform. In the areas which should not be copper-plated, the exposed photoresist has been cross linked or polymerized by the ultraviolet light, becoming insoluble in the methylchloroform developer. It remains on the circuit panel during the development operation.

Next, the circuit panels are electrolessly plated in a copper bath, step 142, with a temperature of about 75°C and a $p_H$ of 11½ to 12. The copper plating rate is approximately 2.0 to 2.3 µm per hour. Twenty to 24 hours are required to plate up to 50 µm.

Following the copper plating, the panels are plated with tin, step 144. The photoresist is then removed, step 146, and the copper 18 etched from the unplated areas, step 148. Finally, the tin is stripped from the circuit lines, step 150.

EN 9.84.009

A problem that may arise in the use of the clear Mylar support layer 10 is indentations in the smooth surface caused by air trapped between the Mylar support sheet 10 and the polyethylene cover sheet 14 when the photoresist structure 9 is in a roll, not shown. These indentations remain for a time after the photoresist structure 9 is laminated onto the substrate 16. If the substrate 16 is plated before the indentations disappear, circuit lines will plate over the top of the depressed resist 9, resulting in variable circuit line width and possibly height. Such defective circuit lines could cause an electrical short circuit with adjacent circuit lines.

To avoid the problem of air entrapment, the smooth polyethylene cover sheet 14 may be matted or textured, enabling the trapped air to escape when the photoresist structure 9 is wound into a roll. The matting of the polyethylene layer 14 may be accomplished by imprinting a pattern on the sheet 14 or by using a matting agent such as silicon dioxide or other small mat-type particles during the manufacturing process. The matting of the polyethylene layer 14 also reduces static electricity when the polyethylene 14 is stripped off and the remaining layers are placed on the substrate 16.

Since other modifications and changes varied to fit particular operating requirements and environments will be apparent to those skilled in the art, the invention is not considered limited to the example chosen for purposes of disclosure, and covers all changes and modifications which do not constitute departures from the true scope of this invention.

CLAIMS

1.  A photohardenable element (9) for use in the manufacture of a substantially defect-free fine line printed circuit board comprising:

    a)   a support layer (10);

    b)   a removable protective cover sheet layer (14) disposed beneath
         said support layer and

    c)   a photoresist layer (12) sandwiched between said support layer
         and said cover sheet layer;

    characterized by said support layer (10) being substantially clear
    to decrease diffraction during radiation exposure.

2.  The element in accordance with claim 1 wherein said support layer
    has a Gardener haze meter value of less than 2%.

3.  The element in accordance with claim 1 or 2 wherein said support
    layer comprises Mylar.

4.  The element in accordance with a previous claim wherein said removable protective cover sheet layer comprises polyethylene.

5.  The element in accordance with a previous claim further comprising:

    d)   a nonconductive plating substrate (16) disposed beneath said
         photoresist layer (13), after said protective cover sheet layer
         (14) is removed.

6.  The element in accordance with any of claims 1-4 wherein said removable protective cover sheet layer (14) is matted to prevent air entrapment when said photohardenable element (9) is rolled and to decrease
    static electricity when said photohardenable element layers (12, 10)
    are separated and placed on said nonconductive plating substrate (16).

7. The element in accordance with claim 5 wherein said substrate (16) comprises glass.

8. The element in accordance with claim 7 wherein said substrate further comprises epoxy.

9. The element in accordance with claim 5 further comprising;

    e)    an electrically conductive material layer (18) disposed on said nonconductive plating substrate (16).

10. The element in accordance with claim 9 wherein said electrically conductive material comprises copper.

11. A method for manufacturing a substantially defect free fine line printed circuit board, the steps comprising:

    a)    providing a photohardenable element (9) comprising:

        i)    a support layer (10),

        ii)    a protective cover sheet layer (14) disposed beneath said support layer, and

        iii) a photoresist layer (12) sandwiched therebetween;

    b)    removing said protective cover sheet layer;

    c)    laminating the remaining two layers of said photohardenable element onto a plating substrate (16) to form a panel;

    d)    providing artwork proximate said support layer of said photohardenable element;

    e)    exposing said artwork and said panel to radiation;

    f)    removing said support layer (10) of said photohardenable element from said panel;

g) developing said panel;

h) plating said panel with an electrical conducting substance to form lines of electrical conductors; and

i) stripping said photoresist layer (12) from said panel;

characterized by said support layer (10) being substantially clear to decrease diffraction during radiation exposure.

12. The method in accordance with claim 11 wherein said plating substrate comprises a copper foil-clad laminate (16, 18).

13. The method in accordance with claim 12, the steps further comprising etching said plating substrate prior to performing step (c).

14. The method in accordance with claim 13, the steps further comprising seeding said plating substrate and/or treating it with a protective material prior to performing step (c).

15. The method in accordance with claim 11 wherein said support layer (10) of said photohardenable element has a Gardener haze meter value of less than 2%.

16. The method in accordance with claim 11 or 15 wherein said support layer of said photohardenable element comprises Mylar.

17. The method in accordance with claim 11 wherein said protective cover sheet (14) of said photohardenable element (9) is patterned to prevent air entrapment when said photohardenable element is rolled and to decrease static electricity when said photohardenable element layers are separated and placed on said plating substrate (16).

18. The method in accordance with claim 11 wherein a hot roll laminating device (20, 22) is used to laminate said photoresist layer and said support layer of said photohardenable element (9) to said plating substrate (16).

0171630

19. The method in accordance with claim 11 wherein said artwork is connected to said support layer of said photohardenable element during exposure to radiation.

20. The method in accordance with claim 11 wherein said radiation is light in the ultraviolet range.

21. The method in accordance with any of claims 11-20, the steps further comprising laminating a conductor comprising a microthin copper layer (18) bonded to a carrier layer with a hardened dielectric material layer (16) prior to step (c), and

removing said carrier layer prior to step (c).

22. The method in accordance with claim 21, the steps further comprising roughening the surface of said microthin copper (18) prior to step (c).

23. The method in accordance with claim 21 or 22, the steps further comprising applying an adhesion promoter prior to step (c).

FIGURE 1.

FIGURE 2.

EN 9.84.009

0171630

```
┌─────────────────────────┐
│    LAMINATE COPPER      │
│  FOIL ONTO SUBSTRATE    │ ── 100
└─────────────────────────┘
            │
┌─────────────────────────┐
│      ETCH COPPER        │ ── 102
└─────────────────────────┘
            │
┌─────────────────────────┐
│       SEED WITH         │
│    PALLADIUM/TIN        │ ── 104
└─────────────────────────┘
            │
┌─────────────────────────┐
│   REMOVE PROTECTIVE     │
│   COVER SHEET LAYER     │ ── 106
└─────────────────────────┘
            │
┌─────────────────────────┐
│    APPLY PHOTORESIST    │
│  STRUCTURE TO SUBSTRATE │ ── 108
└─────────────────────────┘
            │
┌─────────────────────────┐
│   PROVIDE ARTWORK NEXT  │
│   TO PHOTORESIST-COATED │
│        SURFACE          │ ── 110
└─────────────────────────┘
            │
┌─────────────────────────┐
│   EXPOSE PHOTORESIST-   │
│  COATED SURFACE UNDER   │
│        ARTWORK          │ ── 112
└─────────────────────────┘
            │
┌─────────────────────────┐
│   REMOVE MYLAR LAYER    │
│    FROM PHOTORESIST     │ ── 114
└─────────────────────────┘
            │
┌─────────────────────────┐
│     DEVELOP PATTERN     │ ── 116
└─────────────────────────┘
            │
┌─────────────────────────┐
│    PLATE WITH COPPER    │ ── 118
└─────────────────────────┘
            │
┌─────────────────────────┐
│    STRIP PHOTORESIST    │ ── 120
└─────────────────────────┘
```

FIGURE 3.

EN 9.84.009

```
┌─────────────────────────────┐
│   LAMINATE PAP COPPER       │
│   ONTO SUBSTRATE            │──── 124
└─────────────────────────────┘
              │
┌─────────────────────────────┐
│   PEEL OFF CARRIER          │──── 126
└─────────────────────────────┘
              │
┌─────────────────────────────┐
│   ROUGHEN SURFACE           │
│   OF COPPER SUBSTRATE       │──── 128
└─────────────────────────────┘
              │
┌─────────────────────────────┐
│   APPLY BTA                 │──── 130
└─────────────────────────────┘
              │
┌─────────────────────────────┐
│   REMOVE PROTECTIVE         │
│   COVER SHEET LAYER         │──── 132
└─────────────────────────────┘
              │
┌─────────────────────────────┐
│   APPLY PHOTORESIST         │
│   STRUCTURE TO FOIL         │──── 134
└─────────────────────────────┘
              │
┌─────────────────────────────┐
│   PROVIDE ARTWORK           │
│   NEXT TO PHOTORESIST-      │
│   COATED SURFACE            │──── 135
└─────────────────────────────┘
              │
┌─────────────────────────────┐
│   EXPOSE PHOTORESIST-       │
│   COATED SURFACE TO ARTWORK │──── 136
└─────────────────────────────┘
              │
┌─────────────────────────────┐
│   REMOVE MYLAR LAYER        │
│   FROM PHOTORESIST          │──── 138
└─────────────────────────────┘
              │
┌─────────────────────────────┐
│   DEVELOP PATTERN           │──── 140
└─────────────────────────────┘
              │
┌─────────────────────────────┐
│   PLATE WITH COPPER         │──── 142
└─────────────────────────────┘
              │
┌─────────────────────────────┐
│   PLATE WITH TIN            │──── 144
└─────────────────────────────┘
              │
┌─────────────────────────────┐
│   STRIP PHOTORESIST         │──── 146
└─────────────────────────────┘
              │
┌─────────────────────────────┐
│   ETCH COPPER               │──── 148
└─────────────────────────────┘
              │
┌─────────────────────────────┐
│   STRIP OFF TIN             │──── 150
└─────────────────────────────┘
```

FIGURE 4.

EN 9.84.009